# FASCICULE DE BREVET EUROPEEN

(11) **EP 2 448 684 B1**
(45) Date de publication et mention de la délivrance du brevet: **16.12.2015**
(21) Numéro de dépôt: 10742184.4
(22) Date de dépôt: 02.07.2010
(51) Int. Cl.: G03F 7/00, H01L 51/05, B82Y 40/00, B82Y 10/00

(54) **FONCTIONNALISATION DE SURFACES A BASE DE CARBONE, DE SILICIUM ET/OU GERMANIUM HYBRIDES SP3**
FUNKTIONALISIERUNG VON SP3-HYBRIDISIERTEN KOHLENSTOFF-, SILIKON- UND/ODER GERMANIUMFLÄCHEN
FUNCTIONALIZATION OF SP3 HYBRIDIZED CARBON, SILICON, AND/OR GERMANIUM SURFACES

(30) Priorité: 02.07.2009 FR 0954542
(43) Date de publication de la demande: 09.05.2012
(73) Titulaire: Centre National de la Recherche Scientifique (CNRS), 75016 Paris (FR); UNIVERSITE JOSEPH FOURIER, 38041 Grenoble Cédex (FR)
(72) Inventeur: OMNES, Franck Jacques, F-38380 Saint Laurent Du Pont (FR); AGNES, Charles, F-38000 Grenoble (FR); RUFFINATTO, Sébastien, F-38000 Grenoble (FR); MAILLEY, Pascal, F-38730 Le Pin (FR)
(74) Mandataire: Jacobson, Claude
(86) Numéro de dépôt international: PCT/FR2010/051399
(87) Numéro de publication internationale: WO 2011/001123

(56) Documents cités:
- H. KAWARADA ET AL.: "Characterization of Direct Immobilized Probe DNA on Partially Functionalized Diamond Solution-Gate Field-Effect Transistors", JAPANESE JOURNAL OF APPLIED PHYSICS, vol. 45, no. 42, 20 octobre 2006 (2006-10-20), pages L1114-L1117, XP002557786,
- RABAH BOUKHERROUB ET AL.: "Peptide Immobilization on Amine-Terminated Boron-Doped Diamond Surfaces", LANGMUIR, vol. 23, no. 8, 17 mars 2007 (2007-03-17), pages 4494-4497, XP002557787,
- JIN-FANG ZHI ET AL.: "Construction of Two-Dimensional Arrays Gold Nanoparticles Monolayer onto Boron-Doped Diamond Electrode Surfaces", CHEMISTRY OF MATERIALS, vol. 18, no. 4, 28 janvier 2006 (2006-01-28), pages 939-945, XP002557788,
- SABINE SZUNERITS ET AL: "Different strategies for functionalization of diamond surfaces", JOURNAL OF SOLID STATE ELECTROCHEMISTRY ; CURRENT RESEARCH AND DEVELOPMENT IN SCIENCE AND TECHNOLOGY, SPRINGER, BERLIN, DE, vol. 12, no. 10, 4 décembre 2007 (2007-12-04), pages 1205-1218, XP019593237, ISSN: 1433-0768
- T. Strother ET AL: "Photochemical Functionalization of Diamond Films", Langmuir, vol. 18, no. 4, 19 February 2002 (2002-02-19), pages 968-971, XP55045562, ISSN: 0743-7463, DOI: 10.1021/la0112561

## Description

La présente invention concerne une nouvelle méthode de fonctionnalisation de matériaux dont la surface comprend du carbone, du silicium et/ou du germanium, permettant de greffer par liaison forte des composés à la surface de ces matériaux.

La fonctionnalisation de surface de matériaux a de nombreuses applications, notamment, par exemple, dans les domaines de la bioélectronique (biocapteurs, biopuces, biomédical) et de l'électronique moléculaire, où le greffage de composés sur la surface de matériaux conducteurs ou semiconducteurs permet notamment de moduler les propriétés : sensibilité chimique et biochimique, interaction avec l'environnement, photosensibilité, propriétés d'échange électrique et/ou électrochimique, tribologie... Dans ce cadre, il est intéressant de fonctionnaliser des matériaux semiconducteurs présentant un caractère semiconducteurs ou métallique à base de carbone, notamment de diamant, de silicium et/ou de germanium.

La littérature rapporte diverses méthodes de greffage de composés sur des matériaux dont la surface comprend du carbone, du silicium ou du germanium.

Le silicium, et le germanium, qui se comporte généralement de la même façon que le silicium font l'objet de recherches intenses en matière de fonctionnalisation (Buriak, Chem. Rev. 102(5), 1271-1308, 2002). Parmi les méthodes de fonctionnalisation de matériaux dont la surface comprend du silicium peuvent être citées : la silanisation, l'hydrosylilation, l'électrochimie et le greffage de molécules nucléophiles sur du silicium reconstruit.

Le silicium reconstruit est un silicium dont la structure cristalline surfacique a été modifiée dans des conditions d'ultra-vide (typiquement 10⁻¹⁰ bar) et des températures élevées (typiquement supérieures 800 K). Il se produit alors une désorption de l'oxyde natif et une recombinaison des liaisons pendantes adjacentes, pour former en surface d'une manière ordonnée des doubles liaisons de type Si=Si : les atomes de silicium surfacique du silicium reconstruit ont dans cette situation particulière une structure de coordination de type sp². La surface ainsi reconstruite peut être facilement hydrogénée par procédé sous vide. Tout type de composé nucléophile porteur d'un doublet non liant ou insaturé est susceptible de se greffer par liaison dative à la surface du silicium reconstruit hydrogéné, respectivement par substitution nucléophile ou par cycloaddition (Leftwich et al., Surface Science Reports 63, 1-71, 2008). Toutefois, cette voie de greffage présente de nombreux inconvénients :
- la préparation de silicium reconstruit hydrogéné est très complexe et coûteuse ;
- le silicium reconstruit hydrogéné ou non-hydrogéné n'est stable que sous atmosphère inerte (la surface s'oxyde en présence d'eau et/ou d'oxygène) ;
- le greffage de molécules ne peut pas être localisé sur une zone locale et sélectionnée de la surface (la totalité de la surface est nécessairement greffée ou des zones sont greffées localement, mais la localisation s'explique par la morphologie du support, et non par le choix de l'opérateur), et
- le procédé de greffage est long : plusieurs heures d'incubation sont nécessaires.

Par ailleurs, des méthodes de fonctionnalisation de matériaux dont la surface comprend du diamant ont été développées, notamment :
- les méthodes de fonctionnalisation de diamant oxydé en surface, soit à partir de carbonyles (C=O) présents en surface sur le diamant (Notsu et al., Journal of Electroanalytical Chemistry, 493, 31, 2000), soit à partir de groupes hydroxyles (C-OH) présents en surface sur le diamant (Notsu et al., Electrochimical and Solid State Letters 4, H 1, 2001 - Delabouglise et al., Chemical Communications 2698, 2003 - Mazur et al., Langmuir, 21, 8802, 2005),
- les méthodes de fonctionnalisation de diamant par formation de liaison carbone-carbone :
   L'absorption de la lumière UV dans le diamant hydrogéné génère des paires électron-trou dans le volume du matériau, et l'excédent de charge positive résultant des trous photogénérés migrant à sa surface constitue une cible pour une attaque nucléophile par les alcènes (Yang et al., Nature Materials 1, 253-257, 2002).

L'électrochimie est une méthode alternative. Du diamant lourdement dopé au bore est utilisé comme électrode et des sels de diazonium, qui forment des radicaux par réduction, réagissent avec la surface du diamant pour former des liaisons carbone-carbone (Kuo et al., Electrochemical and Solid State Letters 2, 288, 1999 et Delamar et al., Journal of the American Chemical Society 114, 5883, 1992).
- les méthodes de fonctionnalisation de diamant halogéné en surface :
   La surface du diamant peut également être halogénée (fluorination, chlorination). Les halogènes de surface peuvent alors réagir avec d'autres molécules fonctionnelles, par exemple la surface peut être aminée (Ohtani et al., Chemistry Letters, 953, 1998).

Un des enjeux actuels du greffage de molécules à la surface de semiconducteurs est de réaliser un greffage de manière localisée, seulement sur une partie de la surface, ce qui est un avantage pour de nombreuses applications (fabrication de dispositifs électroniques organiques ou de biopuces par exemple).

L'électrochimie est la méthode actuelle de choix pour réaliser un dépôt de molécules de manière localisé. Ainsi, Livache et al. (Journal of Pharmaceutical and Biomedical Analysis 32, 687, 2003) rapportent un greffage localisé par « electrospotting » sur de l'or. Toutefois cette méthodologie nécessite un comportement métallique du matériau support. Ceci implique que seuls le germanium, le carbure de silicium, le diamant et le silicium lourdement dopés (>3.10²⁰ B.cm⁻³ pour le diamant et >10¹⁸ B.cm⁻³ pour le silicium) sont fonctionnalisables par ce moyen. Cette méthode de greffage n'est donc pas généralisable à tout type de germanium, de carbure de silicium, de silicium ou de diamant.

Par ailleurs, la littérature rapporte également le greffage par électrochimie de molécules porteuses de fonction amine sur du carbone de type carbone vitreux ou graphite, dans lesquels les atomes de carbone sont hybridés sp². Plus précisément, dans ces conditions, la fonction amine est oxydée pour former un radical, qui va alors réagir avec le carbone vitreux ou le graphite, ce qui permet le greffage de ces molécules (Deinhammer et al., Langmuir 10, 1306-1313, 1994). Cette méthode présente l'avantage d'être rapide, et de permettre de greffer des molécules sur les surfaces de manière localisée. Toutefois, l'activation électrochimique de fonctions amines requiert un potentiel très élevé qui peut engendrer la dégradation irréversible des fonctions propres de la molécule greffée (fonctions de reconnaissance, de transport électronique, de catalyse...).

Kawarada et al. (Japanese Journal of Applied Physics, 45(42) 2006,1114-117) décrit un procédé de fonctionnalisation d'un matériau comprenant en surface du diamant, comprenant les étapes suivantes :
- hydrogénation d'une surface en diamant par plasma d'hydrogène,
- irradiation sous UV dans de l'oxygène gazeux,
- irradiation sous UV dans un gaz ammoniac,
- greffage d'un brin d'ADN comportant une fonction acide carboxylique terminale activée.

Boukherroub et al. (Langmuir, 2007, 23, 4494-4497) décrit un procédé d'immobilisation d'un peptide sur une surface en diamant dopé bore, comprenant les étapes suivantes :
a) préparation d'une couche de diamant dopé bore sur un substrat silicium par PECVD, pour obtenir un diamant hydrogéné en surface,
b) traitement de la surface obtenue par plasma NH₃ pour obtenir une surface fonctionnalisée par des groupements -NH₂,
c) greffage de peptide par création d'une liaison semi-carbazide.

Zhi et al. (Chemical Materials, 2006,18,939-945) décrit un procédé d'immobilisation de nanoparticules d'or sur une surface diamant dopé bore comprenant les étapes suivantes :
a) synthèse de diamant dopé bore sur un substrat silicium par plasma CVD micro-ondes,
b) greffage d'allyl amine par irradiation UV,
c) immersion dans une solution colloïdale de nanoparticules d'or.

Boukherroub et al. (Journal of Solid State Electrochemistry, 2008, 12,1205-1218) est une revue sur la fonctionnalisation de surfaces en diamant. Plusieurs méthodes pour fonctionnaliser un diamant dont la surface est hydrogénée par une amine sont rapportées : un plasma radio fréquence pour greffer du N-(6-aminohexyl)-aminopropyl trimethoxysilane, une irradiation UV dans de l'ammoniac gazeux, une irradiation UV en présence d'allyl amine, ou traitement par un plasma NH₃ froid.

Strother et al. (LANGMUIR 2002 18 968-971) décrit le greffage d'alcènes par irradiation UV de diamant hydrogéné en surface. Le greffage du 10-amino dec-1-ène est rapporté avec un faible taux de greffage. Pour greffer efficacement un alcène comprenant une fonction amine, il a été nécessaire de protéger la fonction amine soit par un groupe trifluoroacétyle, soit par un Boc.

Un objectif de la présente invention est de fournir une nouvelle méthode permettant d'accéder à des matériaux greffés, notamment des matériaux semiconducteurs greffés, avec la possibilité d'effectuer le greffage de façon localisée.

A cet effet, selon un premier aspect, l'invention fournit un procédé de préparation d'un matériau greffé comprenant les étapes suivantes :
a) fournir un matériau qui comprend en surface des atomes de carbone, silicium et/ou germanium à l'état d'hybridation sp³ et porteurs d'au moins un atome d'hydrogène, et
b) mettre en contact le matériau tel que fourni dans l'étape a) avec un composé (C) porteur d'au moins une fonction amine à l'état non protoné, ledit composé (C) étant au moins partiellement soluble dans ledit solvant, ce par quoi ledit composé (C) se greffe sur ledit matériau.

Dans un mode de réalisation, l'étape b) du procédé est réalisée en présence d'oxygène.

Les travaux réalisés par les inventeurs dans le cadre de la présente invention ont permis de mettre en évidence que la présence d'oxygène favorise en général le greffage des composés (C).

Dans un mode de réalisation, l'étape b) du procédé est réalisée dans un solvant. Le solvant peut être un solvant ou un mélange de plusieurs solvants. Selon un mode de réalisation, le (ou les) solvant(s) utilisé(s) dans le cadre de l'étape b) peu(ven)t être de nature protique. Selon un autre mode de réalisation, le (ou les) solvant(s) utilisé(s) dans le cadre de l'étape b) peu(ven)t être de nature aprotique. Le composé (C) est au moins partiellement soluble dans le solvant, typiquement, le composé (C) est à l'état solubilisé dans le solvant. Lorsque l'étape b) est réalisée dans un solvant, l'étape b) peut notamment consister en un trempage (« dip coating » en anglais) du matériau tel que fourni dans l'étape a) dans ledit solvant, en particulier lorsque l'on souhaite greffer le composé (C) sur la totalité de la surface du matériau.

Par solvant protique, on entend un solvant qui comporte au moins un atome d'hydrogène susceptible d'être libéré sous forme de proton. Le solvant protique est avantageusement choisi dans le groupe constitué par l'eau, l'eau désionisée, l'eau distillée, de préférence basifiée, les solvants hydroxylés comme le méthanol et l'éthanol.

Par solvant aprotique, on entend tout solvant qui n'est pas protique, à savoir qui n'est pas susceptible de libérer ou d'accepter un proton. Le solvant aprotique est avantageusement le diméthylsulfoxyde (DMSO) ou l'acétone.

Le solvant mis en oeuvre lors de l'étape b) peut comporter un agent de régulation de pH, qui permet que la fonction amine du composé (C) soit à l'état non protoné. Cet agent de régulation de pH est de préférence soluble dans le solvant. Par exemple, lorsque le solvant est du DMSO, celui-ci est de préférence saturé par une base de Brönsted comme l'hydroxyde de potassium.

De préférence, lorsque l'étape b) est mise en oeuvre dans un solvant, la concentration en composé (C) dans le solvant est de 10 nM à 1 M, notamment de 100nM à 100mM, en particulier de 1 mM à 10mM.

Dans un mode de réalisation, l'étape b) du procédé est réalisée en présence d'eau.

Dans un mode de réalisation préféré, l'étape b) du procédé est réalisée en présence d'oxygène et d'eau.

Le greffage des composés (C) est facilité lorsque de l'oxygène et de l'eau sont présents dans le milieu réactionnel.

Les inventeurs ont découverts de manière surprenante que la mise en oeuvre des étapes a) et b) permet de greffer des composés (C) porteurs d'au moins une fonction amine à la surface d'un matériau dont la surface comprend des atomes d'au moins l'un des éléments carbone, silicium ou germanium (éléments non métalliques de la colonne IV de la classification périodique) à l'état d'hybridation sp³ et porteurs d'au moins un atome d'hydrogène.

Le procédé présente l'avantage de permettre le greffage de composés (C) porteurs d'au moins une fonction amine à la surface d'un matériau sans apport énergétique externe (sans irradiation, plasma, énergie thermique...).

Le procédé selon l'invention a l'avantage d'être applicable sur tout matériau dont la surface comporte du silicium, du germanium et/ou du diamant hydrogéné. De préférence, les matériaux ont une surface qui comporte du diamant, du silicium, du germanium et/ou du carbure de silicium. Dans les matériaux mis en oeuvre dans le procédé selon l'invention, le carbone, le silicium et/ou le germanium sont généralement cristallins. Le silicium, germanium, carbone et/ou carbure de silicium utilisés peuvent être sous forme mono- ou polycristalline. De plus, le silicium, le diamant, le germanium et le carbure de silicium, dopés ou non, peuvent donc être isolant, semi-conducteur ou conducteur. Le procédé est en effet indépendant de la conductivité électrique du silicium, germanium, carbone et/ou carbure de silicium utilisés, ce qui présente un avantage notoire vis-à-vis de la méthode de greffage par électrochimie.

Les autres éléments de la colonne IV (éléments métalliques : étain et plomb) ne sont pas adaptés. En effet, les liaisons hydrogène-métal tels que Sn-H ou Pb-H sont extrêmement instables et semblent incompatibles avec la mise en oeuvre de la méthodologie ici décrite.

Lors de l'étape a), il est fourni un matériau dont la surface comprend des atomes d'au moins l'un des éléments carbone, silicium et/ou germanium et porteurs d'au moins un atome d'hydrogène. La surface de ce matériau comporte donc des hydrogènes de surface liés par des liaisons C-H, Si-H et/ou Ge-H. En fonction du type de greffage recherché, tout ou partie de ces atomes de carbone, silicium et/ou germanium de surface est porteur d'atomes d'hydrogène. Selon un mode de réalisation particulier, essentiellement tous les atomes de carbone, silicium et/ou germanium de surface sont hydrogénés (typiquement au moins 95% sont hydrogénés).

Le matériau fourni dans l'étape a) comprend en surface des atomes de carbone, silicium et/ou germanium à l'état d'hybridation sp³, c'est-à-dire que chacun de ces atomes de surface est lié à quatre atomes voisins par des liaisons sigma, sans liaison double ou multiple avec un atome voisin. Le carbone hybridé sp³ est principalement du diamant mais peut être constitutif du carbure de silicium.

Tout ou partie de ces atomes de surface hybridés sp³ sont hydrogénés. De préférence, au moins 95% des atomes de carbone, silicium et/ou germanium en surface sont à l'état d'hybridation sp³. Selon un mode de réalisation particulier, tous les atomes de surface de carbone, silicium et/ou germanium sont à l'état d'hybridation sp³ et le matériau est exempt en surface d'atomes de carbone, silicium et/ou germanium à l'état d'hybridation sp². En particulier, le matériau selon l'invention ne comprend généralement pas, et n'est généralement pas, du silicium, diamant ou germanium reconstruit, du DLC (diamond like carbon ou diamant amorphe), du graphite ou du carbone vitreux.

Dans un mode de réalisation préféré du procédé, le matériau comprend au moins une couche de surface constituée de l'un des éléments choisis parmi le carbone, le silicium, le germanium et leurs mélanges.

De préférence, le matériau comprend au moins une couche de surface constituée de diamant, de silicium ou de carbure de silicium.

Le matériau peut également être constitué de l'un des éléments choisis parmi le carbone, le silicium, le germanium et leurs mélanges. Le matériau peut notamment être constitué de diamant, de silicium ou de carbure de silicium.

Dans un mode de réalisation du procédé, le matériau comprend en surface du diamant de synthèse, de préférence fraîchement préparé, par exemple en sortie de bâti de croissance d'une méthode de croissance en phase vapeur (CVD).

Le « diamant de synthèse » correspond à un diamant fabriqué par l'homme, à la différence du diamant naturel. Il peut être fabriqué par des procédés de croissance Haute Pression-Haute Température (HPHT) ou par des techniques de croissance en phase vapeur (CVD). Les processus de synthèse par CVD donnent lieu à des surfaces essentiellement hydrogénées. Par contre, le diamant HPHT n'est pas nécessairement obtenu sous forme hydrogénée en fin de synthèse.

Dans un mode de réalisation, le matériau fourni dans l'étape a) est issu d'une étape d'hydrogénation d'un matériau initial dont la surface comporte des atomes de carbone, silicium et/ou germanium à l'état d'hybridation sp³, initialement non hydrogénés ou non totalement hydrogénés.

Dans ce mode de réalisation, la surface du matériau n'est initialement pas hydrogénée ou ne l'est que partiellement. On commence par hydrogéner la surface du matériau avant de greffer le composé (C) porteur d'une fonction amine.

Par « hydrogénation », on désigne la réaction physico-chimique par laquelle des liaisons [carbone, germanium ou silicium]-hydrogène sont créées. L'hydrogénation peut être effectuée par toutes les méthodes connues de l'homme du métier. Parmi celles-ci peuvent notamment être citées l'hydrogénation du diamant par plasma H₂ (L. Ley, R. Graupner, J. B. Cui, and J. Ristein, Carbon 37, 793, 1999) ou l'hydrogénation du silicium par traitement à l'acide fluorhydrique.

Dans un mode de réalisation particulier du procédé, le matériau fourni dans l'étape a) est issu d'une étape d'hydrogénation par plasma H₂ d'un matériau initial dont la surface comporte du diamant, du silicium ou du germanium, initialement non hydrogéné ou partiellement non hydrogéné. De préférence, l'hydrogénation du diamant par plasma H₂ est effectuée par plasma micro-onde. Dans ce mode de réalisation, le diamant peut notamment être un diamant non hydrogéné ou partiellement hydrogéné obtenu par des procédés de croissance Haute Pression-Haute Température (HPHT).

A noter que l'hydrogénation du diamant (en sortie de bâti de croissance ou après hydrogénation par plasma H₂) perdure, même si un vieillissement à l'air aboutit à une perte partielle des fonctions carbone-hydrogène de surface, typiquement 15% après une semaine d'exposition à l'air (Vanhove et al., PSSA, 204(9), 2931-2939, 2007). Il apparaît ainsi des groupements de surface du type carboxyles (COOH), carbonyles (C=O), hydroxyles (C-OH), ponts éther (C-O-C). Le procédé présente l'avantage d'être applicable aussi bien sur du diamant juste après hydrogénation que sur du diamant vieilli.

Dans un autre mode de réalisation particulier du procédé, le matériau fourni dans l'étape a) est issu d'une étape d'hydrogénation par traitement par de l'acide fluorhydrique d'un matériau initial dont la surface comporte du silicium ou du germanium initialement non hydrogéné ou partiellement non hydrogéné.

La surface du silicium est recouverte d'une couche de silice native qui se développe spontanément. Lorsque cette surface est traitée par de l'acide fluorhydrique, la silice se dissout, ce qui permet d'obtenir du silicium hydrogéné.

Généralement, il est préférable de réaliser l'étape b) dans les plus brefs délais après hydrogénation de la surface du silicium. En effet, le silicium hydrogéné est soumis au phénomène de passivation, et le greffage du composé (C) par le procédé selon l'invention est donc en compétition avec la passivation.

Dans l'étape b), il est fourni des composés (C) porteurs d'une fonction amine qui est propre à réagir avec la surface hydrogénée du matériau fourni dans l'étape a). Par « fonction amine », on entend ici une fonction qui comprend un atome d'azote comprenant un doublet d'électron non-liant et de structure ammoniac substituée par un ou plusieurs atomes, notamment par un ou plusieurs atomes de carbone de type aliphatique ou aromatique. Sont notamment comprises dans la définition de fonction amine selon l'invention les fonctions amine primaire (monosubstitution), secondaire (disubstitution) et tertiaire (tris-substitution), les fonctions amidine et guanidine. Le composé (C) porteur de la fonction amine peut être aliphatique (éthylamine, diméthylamine, triéthylamine...), hétérocyclique saturé (pipéridine, pipérazine...), ou encore aromatique (de type aromatique substitué comme l'aniline, ou hétérocyclique insaturée comme la pyridine, la purine, la pyrimidine...). Selon la définition précitée, les fonctions amides, urées et carbamates, où le doublet de l'azote n'est pas disponible, ne sont pas des fonctions amines.

Dans un mode de réalisation préféré du procédé, la fonction amine est une fonction amine primaire ou secondaire. De préférence, il s'agit d'une amine primaire. De façon particulièrement préférée, la fonction amine est une fonction amine primaire, pour une accessibilité maximale du doublet non-liant.

Le composé (C) porteur d'au moins une fonction amine peut comprendre une ou plusieurs fonctions amines, identiques ou différentes.

Le composé (C) est éventuellement porteur d'autres fonctions organiques que la fonction amine (carboxyle, ester, hydroxyle, thiol, aldéhydes, cétones, époxy, carbamate, insaturation...), ce par quoi on obtient un matériau sur lequel sont greffés des composés porteur d'une fonction organique. Cette fonction organique peut permettre une potentielle post-fonctionnalisation, notamment par création d'une liaison covalente, de Van der Walls ou hydrogène (par exemple greffage d'un brin d'ADN capable de reconnaitre un autre brin d'ADN dans le cas d'une biopuce à ADN), ou constitue directement la fonctionnalité désirée. Le composé (C) peut également comprendre une ou plusieurs fonctions capable(s) de se complexer à des entités biologique et/ou chimiques (par exemple un métal ou un cation)

Le composé (C) porteur d'une fonction amine est notamment une molécule fonctionnelle qui peut être par exemple une molécule active au sens du transfert d'énergie (échange électronique ou photoélectronique, absorption moléculaire, fluorescence, transport d'électron...) telle que : un complexe métallique, un complexe bioinorganique (par exemple un complexe de porphyrine de fer), un composé redox bioorganique (par exemple les flavines ou les ubiquinones), organique ou organo-inorganique, un fluorophore, un chromophore, ou une molécule biologique, notamment choisie parmi l'ADN (acide désoxyribonucléique), l'ARN (acide ribonucléique), une protéine, un peptide, une enzyme, un anticorps, un carbohydrate. Des dérivés d'amine porteurs d'une chaîne aliphatique, insaturée ou fluorée hydrophobe ou des composés hydrophiles peuvent être utilisés en tant que composé (C) porteur d'une fonction amine.

Dans les conditions de l'étape b), les composés (C) introduits sont porteurs d'une fonction amine qui est à l'état non protoné, c'est-à-dire que la fonction amine n'est pas sous forme de son sel d'acide. Ainsi, le doublet non liant de l'amine est disponible. Le milieu réactionnel peut toutefois comprendre un mélange de composés (C) porteurs de fonctions amines sous forme neutre et à l'état protoné, l'essentiel étant qu'au moins certains des composés (C) présents soient porteurs d'une amine non protonée.

De façon à ce qu'au moins une partie des fonctions amines présentes soient non protonées, le milieu réactionnel est alcalin ou neutre. Avantageusement, l'étape b) est conduite en milieu neutre, typiquement à un pH de l'ordre de 6 à 8, ce qui permet de réaliser le greffage de composés (C) sensibles, notamment des biomolécules. En général, l'étape b) est conduite en milieu basique.

De préférence, le matériau obtenu à la fin de l'étape b) est récupéré. A cet effet, la phase liquide du milieu réactionnel de l'étape b) est éliminée pour obtenir le matériau, qui est alors rincé, par exemple par des solutions tampons et/ou de l'eau, puis séché, pour obtenir le matériau greffé.

Le procédé selon l'invention présente de nombreux avantages. Tout d'abord, les étapes peuvent être mises en oeuvre dans des conditions douces, ce qui permet de ne pas dénaturer les composés (C) porteurs d'au moins une fonction amine utilisées. En pratique, le procédé est en particulier applicable à la plupart des composés chimiques porteurs d'une fonction amine, notamment à ceux accessibles dans le commerce.

Le greffage de composés (C) par le procédé précité présente l'avantage d'être généralement très rapide, à savoir généralement de l'ordre de la minute, ce qui est beaucoup plus rapide que d'autres méthodologies de greffage, comme par exemple la photochimie ou la silanisation, qui nécessite des temps de greffage généralement de l'ordre de quelques heures.

Dans les conditions de l'étape b), les composés (C) introduits sont porteurs d'une fonction amine qui est à l'état non protoné, c'est-à-dire que la fonction amine n'est pas sous forme de son sel d'acide (ammonium quaternaire). Ainsi, le doublet non-liant de l'amine est disponible.

On travaillera préférentiellement à un pH tel que toutes les amines introduites dans le milieu réactionnel soient non protonées, soit en milieu basique, (pH > 8). Toutefois, pour des molécules chimiquement fragiles (molécules biologiques, complexes métalliques...) il est possible de travailler à des pH plus doux (proche de la neutralité, pH 6-8) ou seulement une fraction des amines introduites sont déprotonées.

De préférence, le matériau obtenu à la fin de l'étape b) est récupéré. A cet effet, la phase liquide du milieu réactionnel de l'étape b) est éliminée pour obtenir le matériau, qui est alors rincé, par exemple par des solutions tampons et/ou de l'eau, puis séché ou conditionné, pour obtenir le matériau greffé et le stocker.

Le procédé selon l'invention présente de nombreux avantages. Tout d'abord, les étapes peuvent être mises en oeuvre dans des conditions douces, ce qui permet de ne pas dénaturer les composés (C) porteurs d'au moins une fonction amine utilisés. En pratique, le procédé est en particulier applicable à la plupart des composés chimiques porteurs d'une fonction amine, notamment à ceux accessibles dans le commerce.

Le greffage de composés par le procédé précité présente l'avantage d'être généralement très rapide, à savoir généralement de l'ordre de la minute. Cette rapidité d'exécution est un atout favorable pour effectuer la fonctionnalisation dans des petits volumes, donc soumis à une forte évaporation, permettant ainsi de rationnaliser le greffage de molécules à haute valeur ajoutée.

Le procédé selon l'invention présente l'avantage d'être simple, peu coûteux et permet le greffage de composés (C) en une seule étape réactionnelle à partir de matériau hydrogéné : l'étape b).

Sans vouloir être lié par une théorie particulière, les travaux des inventeurs permettent d'avancer que le greffage peut être effectué :
- soit les composés (C) porteurs d'au moins une fonction amine se greffent à la surface grâce au carbone/silicium/germanium hydrogéné par l'intermédiaire de leur fonction amine lors de l'étape b). L'azote de la fonction amine du composé (C) porteur d'une fonction amine mis en contact lors de l'étape b) est un des atomes qui participe à la liaison entre le composé (C) et la surface. Pour ce faire, la réaction de l'étape b) est conduite dans des conditions qui permettent la formation de la liaison entre l'atome d'azote de la fonction amine du composé (C) et la surface.
- soit, l'atome d'azote est éliminé lors de la réaction et c'est l'atome de carbone en alpha de l'azote qui se greffe au matériau par création d'une liaison covalente.

Quel que soit les atomes mis en oeuvre dans les liaisons entre les composés (C) et la surface, des liaisons fortes sont créées entre le composé (C) et le matériau. Les inventeurs ont ainsi mis en évidence que ces liaisons ne sont généralement pas rompues en mettant le matériau dont la surface est greffée en conditions acide fort ou base forte, avec ou sans sonication, ce qui laisse supposer que les liaisons créées sont covalentes. La stabilité chimique des liaisons créées est un avantage supplémentaire du procédé.

De préférence, l'étape b) est réalisée en milieu aqueux. Par « milieux aqueux », on désigne des milieux constitués principalement d'eau, de préférence des solutions aqueuses. Généralement, le pH du milieu aqueux est supérieur ou égal au pKa de l'amine du composé (C) mise en oeuvre dans l'étape b), ce qui permet de s'assurer que la majorité des amines sont non protonées dans le milieu et de greffer le composé (C). Des solutions aqueuses de phosphate ou d'hydrogénocarbonate sont particulièrement préférées. Pour limiter les phénomènes de séchage, un agent permettant de retarder le séchage, comme du glycérol (Sigma Aldrich^{®}), peut être ajouté.

Selon un mode de réalisation avantageux, lorsque l'étape b) des procédés précités est réalisée dans un solvant, le solvant est saturé à l'air.

Dans un mode de réalisation, lors de l'étape b), le matériau est polarisé anodiquement à un potentiel électrochimique compris entre -0.5 et 0.9V vs Ag/AgCl. Le potentiel est généralement inférieur au potentiel d'oxydation de la fonction amine (de l'ordre de 1,3 V *vs* Ag/AgCl). Ce potentiel permet une migration forcée du composé (C) porteur de la fonction amine si celui-ci est chargé positivement (potentiel appliqué négatif, préférentiellement compris entre 0 et -500 mV *vs* Ag/AgCl) ou négativement (potentiel appliqué inférieur au potentiel d'oxydation de l'amine et préférentiellement compris entre 0 et +900 mV *vs* Ag/AgCl). L'application d'un potentiel peut s'avérer intéressante pour travailler dans des solutions de très faibles concentrations, mais n'est généralement pas nécessaire pour obtenir le greffage recherché selon l'invention.

Ce potentiel est susceptible, au moins dans certains cas de renforcer le rôle d'accepteur d'électron de la surface et d'améliorer le greffage.

Ce mode de réalisation est particulièrement adapté pour des matériaux de type métallique ou semiconducteurs fortement dopés.

De préférence, le procédé de greffage selon l'invention (étape b) est réalisé à température ambiante, à pression atmosphérique et sous air. Le procédé selon l'invention ne nécessite pas l'illumination de la surface dans l'UV.

Dans un mode de réalisation du procédé, l'étape b) est réalisée sur une partie déterminée de la surface.

Le procédé présente l'avantage de pouvoir être effectué sur une partie déterminée de la surface, c'est-à-dire que le greffage de composés (C) de façon localisée sur la surface est possible de l'échelle millimétrique à l'échelle nanométrique. La zone localisée de mise en contact peut être centimétrique (ayant typiquement une dimension caractéristique entre 1 et 100 cm), millimétrique (ayant typiquement une dimension caractéristique entre 1 et 100 mm), micrométrique (ayant typiquement une dimension caractéristique entre 1 et 1000 µm, notamment entre 1 et 100 µm) ou nanométrique (ayant typiquement une dimension caractéristique entre 1 et 1000 nm, notamment entre 1 et 100 nm). La possibilité d'effectuer des dépôts localisés est très avantageuse car elle permet de nombreuses applications nécessitant un multiplexage chimique de la surface, par exemple pour la fabrication de biopuces ou de biocapteurs, pour lesquels la possibilité de créer sur la surface d'un matériau de nombreuses zones localisées ayant échelle la plus faible possible est essentielle car le biocapteur ou la biopuce obtenus à partir d'un tel matériau est avantageusement miniaturisé tout en permettant des détections multiples des entités chimiques ou biologiques dont les présences doivent être testées. De plus, la miniaturisation de composants pour l'électronique, l'optoélectronique, l'électronique moléculaire, la bioélectronique est également recherchée.

Cette localisation peut être menée par différents moyens technologiques incluant le dépôt de goutte (spotting, drop-casting, ink-jet printing), les procédés de couchage (stamping, sérigraphie, flexographie, héliographie, micro-contact printing), de lithographie, encore d'écriture en champ proche (AFM, nanofountain pen, dip pen lithography) ou de fonctionnalisation de surface dans un canal micro- ou nano-fluidique.

Les articles suivants illustrent certains des moyens technologiques utilisables pour effectuer un greffage localisé et mettent en avant les avantages de la localisation et les applications qu'un matériau greffé et fonctionnalisé de façon localisée peut avoir : a) E. Descamps et al. Adv. Mater., 19 (2007) 1816-1821. (biopuce à ADN) - b) Y. Roupioz et al. Small 5 (2009) 1493-1497 (organisation d'un réseau d'objets uniques) - c) M. Geissler et al., Adv. Mater. 2004, 16, 1249 ; A. N. Shipway et al., ChemPhysChem 2000, 1, 18 (intérêt du multiplexage et applications en photonique, électronique moléculaire, et biocapteurs) - d) S. H. Hong et al., Science 1999, 286, 523. (dip pen nanolithography, multiplexage) - e) K. T. Rodolfa et al., Nano Lett. 2006, 6, 252. (nanofountain pen).

A la connaissance des inventeurs, le procédé selon l'invention est le premier procédé permettant de greffer des composés, notamment des composés (C) porteurs d'une fonction amine, sur des matériaux dont la surface comprend du silicium, du germanium et/ou du carbone hybridé sp³, en particulier sans qu'il soit nécessaire que le matériau soit dopé.

Dans un autre mode de réalisation, l'étape b) est réalisée sur la totalité de la surface, notamment par trempage dans un solvant, comme explicité ci-dessus.

Les matériaux greffés susceptibles d'être obtenus par l'un des procédés précités sont décrits ci-après.

De préférence, le matériau a été greffé par des composés (C) de façon localisée sur une partie déterminée de la surface, ce qui présente les avantages susmentionnés.

La surface du matériau greffé obtenu par le procédé est fonctionnalisée par des composés (C). Une monocouche plus ou moins compacte de composés est obtenue en surface. La compacité de la monocouche peut toutefois être augmentée lorsque l'étape b) est réalisée à pH basique (c'est-à-dire tel que le pH soit supérieur au pKa de l'amine) et en augmentant le temps de réaction de l'étape b).

Le matériau greffé obtenu par le procédé est donc fonctionnalisé en surface par des composés (C) qui peuvent comporter des groupes fonctionnels (en plus de la fonction amine servant au greffage). Ces groupes fonctionnels peuvent ainsi conférer à la surface une fonction d'intérêt pour des applications dans les domaines de l'électronique, l'optoélectronique, l'électronique moléculaire, la bioélectronique, l'environnement, la tribologie, le photovoltaïque et le biomédical.

Le matériau greffé tel qu'obtenu selon le procédé précité est utile pour la préparation, par exemple, de biocapteurs, de biopuces, de composants pour l'électronique, l'optoélectronique, l'électronique moléculaire, la bioélectronique, l'environnement, la tribologie, le photovoltaïque et le biomédical.

Lors de la fabrication de dispositifs d'électronique moléculaire (circuit intégré, circuit logique, stockage de données...) et bioélectronique (biopuces, biocapteurs, électrodes médicales...), les matériaux peuvent notamment être employés comme suit :
- selon une approche pré-fonctionnelle, en greffant des composés (C) porteurs d'une fonction amine, et de préférence porteurs d'autres fonctions organiques que la fonction amine, sur un matériau en utilisant le procédé selon l'invention, puis en implémentant le matériau (de préférence fonctionnel) obtenu dans la fabrication d'un dispositif (bio-)électronique, ou
- selon une approche post-fonctionnelle, en fabriquant le dispositif électronique par des méthodes connues de l'homme du métier puis en modifiant chimiquement par greffage de composés (C) porteurs d'une fonction amine, et de préférence porteurs d'autres fonctions organiques que la fonction amine. Dans ce cas, la fonctionnalisation intervient en tant qu'étape finale pour implémenter localement des fonctions sur le circuit intégré/biocapteur/biopuce. Les aspects rapidité du greffage, possibilité de localisation et procédé réalisé dans des conditions douces sont particulièrement avantageux pour ces utilisations.

Les matériaux employés pour les utilisations précitées sont typiquement des matériaux susceptibles d'être obtenus par le procédé selon l'invention à partir d'un matériau initial qui comprend en surface des atomes de carbone, silicium et/ou germanium semiconducteurs.

Le circuit d'électronique moléculaire est un composant électronique reproduisant une ou plusieurs fonctions électroniques plus ou moins complexes, dont l'une au moins des fonctions est assumée par un édifice moléculaire fonctionnel, intégrant souvent plusieurs types de composants électroniques de base dans un volume réduit, rendant le circuit facile à mettre en oeuvre.

Lorsqu'un matériau tel qu'obtenu par le procédé de l'invention comprend du silicium semi-conducteur, il peut être utilisé en tant que « wafer », qui est un disque assez fin de matériau semi-conducteur qui sert de support à la fabrication de micro-structures par des techniques telles que le dopage, la gravure, la déposition d'autres matériaux (épitaxie, sputtering, CVD, ...) et la photolithographie. Il est d'une importance cruciale dans la fabrication des circuits intégrés.

Un dispositif bioélectronique est un dispositif tel que précédemment décrit mais qui intègre une fonction biologique sélective. La partie inorganique du dispositif sert alors de transducteur à un phénomène de reconnaissance biomoléculaire orienté par la biomolécule ou biorécepteur. Un biocapteur est ainsi constitué d'un biorécepteur d'origine biologique: enzyme, anticorps, récepteur... et d'un transducteur chargé de convertir le signal biologique (qui par exemple sera la fixation de l'antigène à détecter sur l'anticorps) en un signal aisément exploitable (généralement électrique ou lumineux).

Une biopuce correspond à une parallélisation plus ou moins massive d'un ensemble de biorécepteurs comme des molécules d'ADN ou de tout autre élément de reconnaissance moléculaire (peptide, protéine, anticorps, carbohydrate, petit ligand, récepteur, aptamère) fixés en rangées ordonnées sur une petite surface du matériau. Les biopuces permettent une analyse quantitative multiparamétrique des évènements biologiques afin, par exemple, de quantifier le niveau d'expression des gènes (transcrits) dans une cellule d'un tissu donné (foie, intestin...), à un moment donné (embryon, adulte...) et dans un état donné (malade, saine...).

En particulier, un matériau greffé par un composé (C), notamment de type, et comportant une ou plusieurs autre fonction organique capable de se lier (notamment par liaison covalente, hydrogène, Van der Waals, complexation...) à une entité chimique ou biologique, le matériau permet alors la détection, voire la quantification de l'entité chimique ou biologique et peut ainsi être utilisé comme biocapteur. En particulier, lorsque le composé (C) est une molécule biologique, notamment telle que définie ci-dessus, et comportant une ou plusieurs autre fonction organique capable de se lier à une entité biologique, le matériau peut être utilisé comme biopuce.

L'invention sera encore davantage illustrée au moyen des figures ci-annexées et exemples ci-après.

### FIGURES

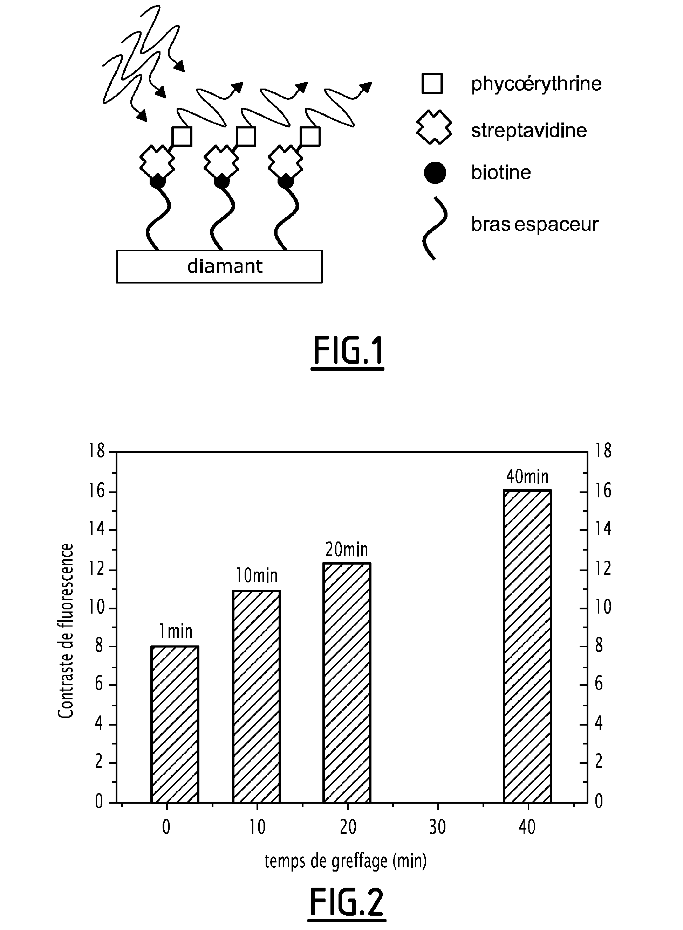

La figure 1 représente le schéma de principe de la fluorescence utilisé dans tous les exemples.
La figure 2 représente le contraste de fluorescence en fonction de la durée de la réaction de greffage (40min, 20min, 10min et 1 min) de la biotine-PEO2-amine (1 mM) sur la surface du diamant (phosphate 0,1 M, pH 11, 20% glycérol) (exemple 1).

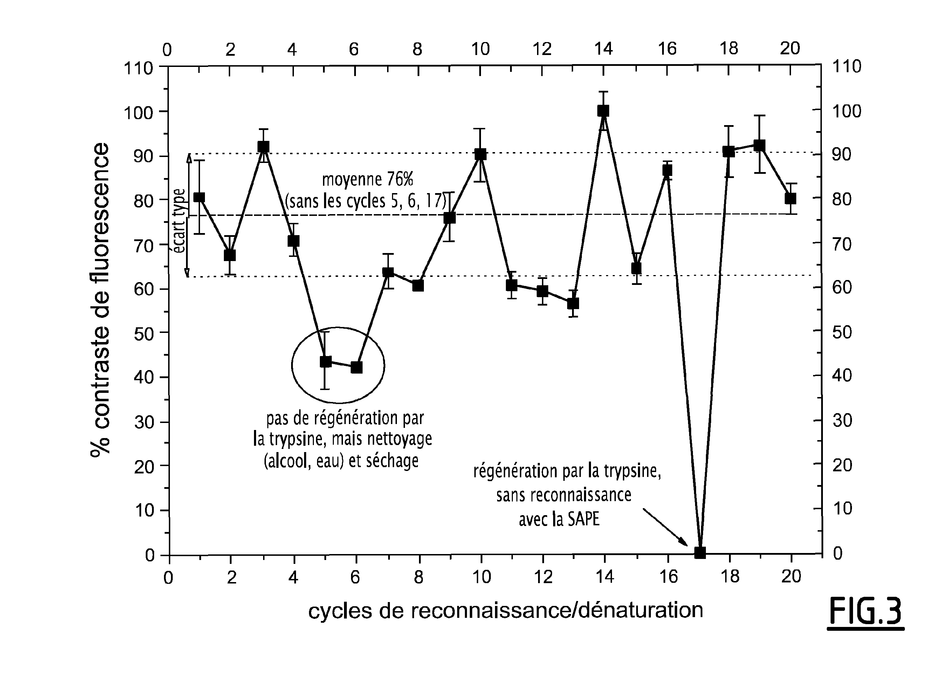

La figure 3 présente l'évolution relative du contraste de fluorescence (exprimée en % du contraste maximal) en fonction du nombre de cycles de reconnaissance-dénaturation du complexe biotine greffée/SAPE : sans régénération des biotines pour les cycles 5 et 6 ; avec régénération des biotines par la trypsine pour les cycles 1-4 et 7-20, mais sans reconnaissance avec la SAPE pour le cycle 17 (exemple 1).

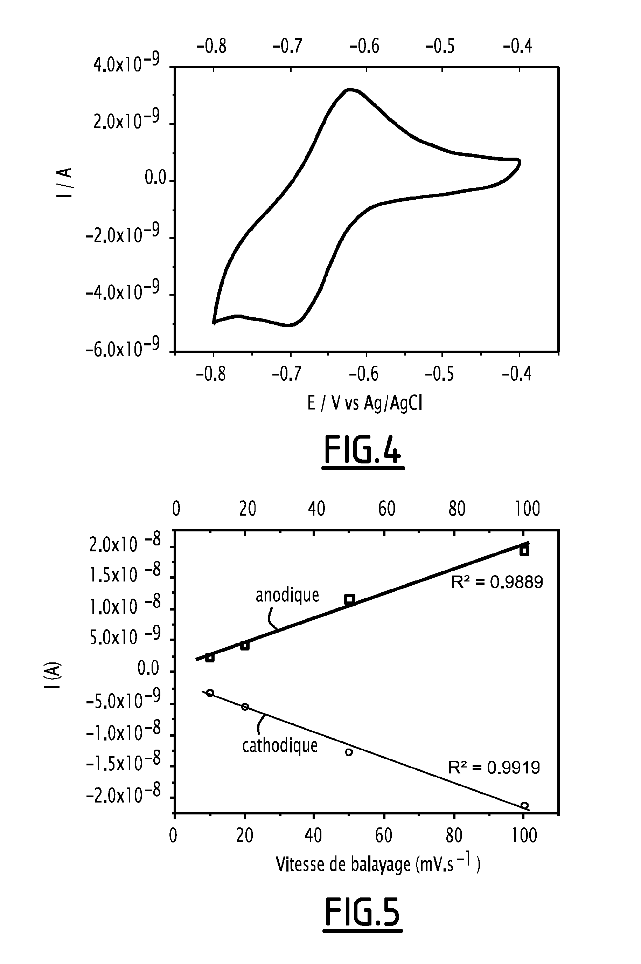

La figure 4 représente un voltampérogramme enregistré pour une surface de diamant fonctionnalisée par une PyridoAcridone artificielle (notée PyAc) dans une solution de phosphate 0,1 M à pH 6,2, avec une vitesse de balayage de 10mV/s (Greffage du PyAc : 1 mM de PyAc dans du phosphate 0,1 M avec 20% de glycérol, à pH 11, et avec une durée de greffage de 30 min) (exemple 4).
La figure 5 représente l'évolution de l'intensité du courant des pics d'oxydation et de réduction en fonction de la vitesse de balayage d'une surface de diamant fonctionnalisée par une PyridoAcridone artificielle (notée PyAc) (Greffage du PyAc : 1 mM de PyAc dans du phosphate 0,1 M avec 20% de glycérol, à pH 11, et avec une durée de greffage de 30 min) (exemple 4).

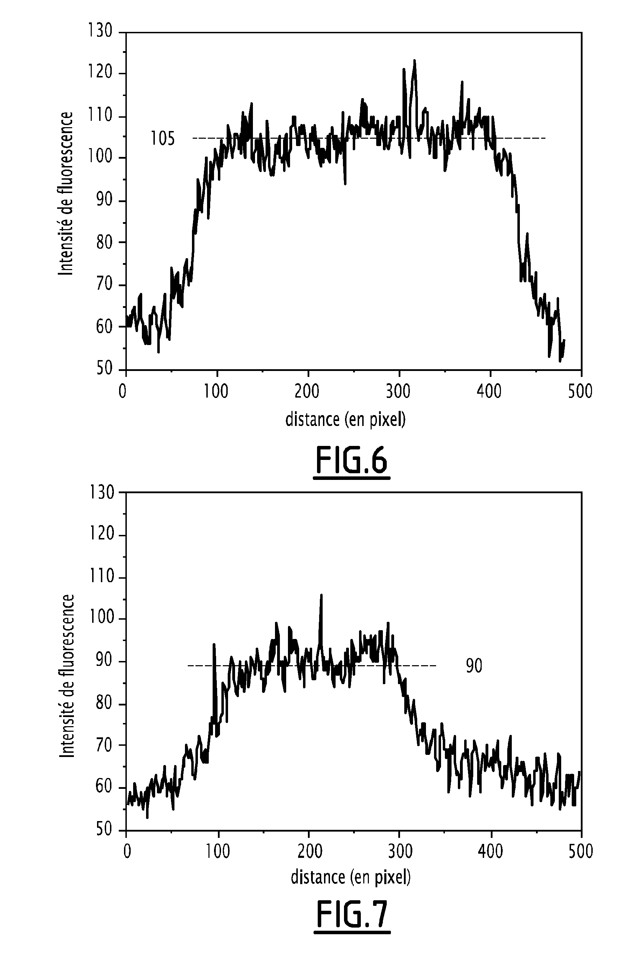

La figure 6 représente l'intensité de la fluorescence d'une image de fluorescence révélée par la SAPE du greffage de la biotine-PEO2-amine sur silicium, dans des conditions normales (tampon phosphate 0,1 M, pH 11, temps de contact 5 minutes, concentration de la biotine-PEO2-amine de 15mM) en fonction de la distance (exemple 5).
La figure 7 représente l'intensité de la fluorescence d'une image de fluorescence révélée par la SAPE du greffage de la biotine-PEO2-amine sur silicium, dans une solution partiellement désoxygénée (tampon phosphate 0,1 M, pH 11, temps de contact 5 minutes, concentration de la biotine-PEO2-amine de 15mM) en fonction de la distance (exemple 5).

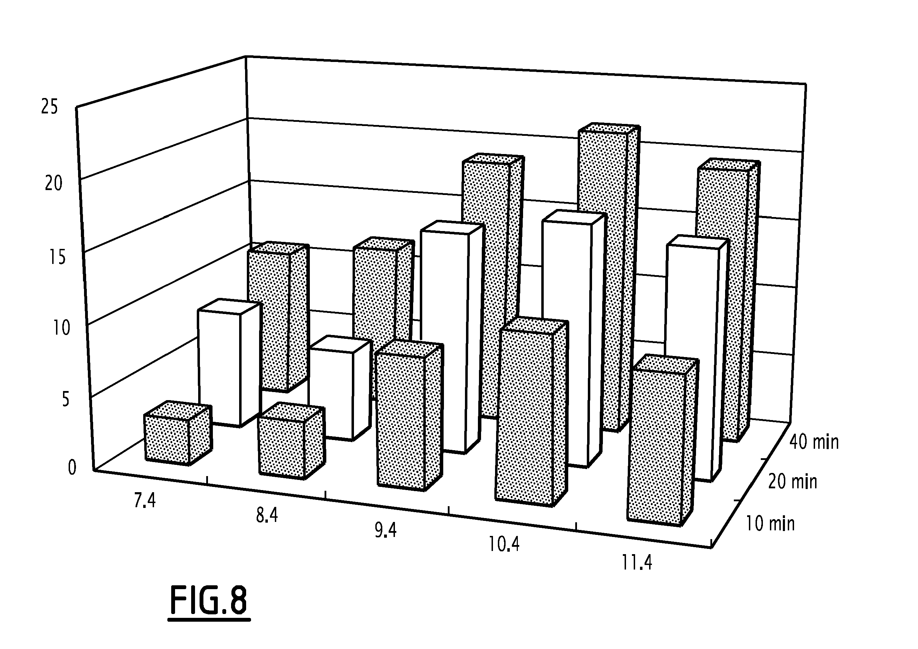

La figure 8 représente les histogrammes des intensités de fluorescence d'images de fluorescence révélée par la SAPE du greffage de la biotine-PEO2-amine observées pour chacun des 15 couples [pH de la solution lors du greffage - durée de greffage].

### EXEMPLES

### EXEMPLE 1 : Greffage de la biotine-PEO2-amine (amine primaire aliphatique) sur le diamant

Les solutions aqueuses utilisées sont des solutions de phosphate 0,1 M à pH 11 ou des solutions tampons d'hydrogénocarbonate 0,1M à pH 11. Le pH joue un rôle prépondérant dans le greffage, il permet la déprotonation de l'amine, ce qui renforce son caractère nucléophile. En raison de la faible dimension des plots, du glycérol (Sigma Aldrich^{®}) a été ajouté aux solutions aqueuses à hauteur de 1-20% en volume de manière à limiter les phénomènes de séchage, dans le temps de fabrication de la puce, que l'on a observé initialement sans ajout de glycérol.

Pour préparer la solution de greffage, 15 ml de glycérol ont été dissous dans 35 ml d'eau ultra pure. 710 mg de phosphate de sodium (Na₂HPO₄) ont été dissous dans 50 ml de la solution eau-glycérol préalablement préparée, puis le pH a été ajusté à 11 avec de l'hydroxyde de sodium (NaOH) 3M. 19 mg de biotine-PEO2-amine (Pierce^{®}) ont été dissous dans la solution précédemment préparée. 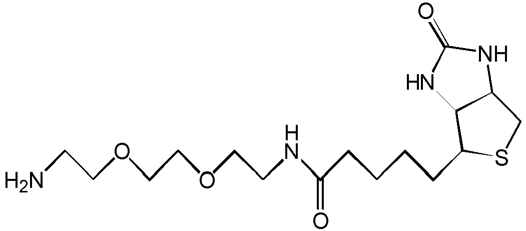 Structure de la biotine-PEO2-amine.

Une aiguille d'une contenance de 80 µl a alors été remplie (voir partie spotting pour l'explication sur l'appareil de dépôt automatique), qui a déposé une goutte par contact avec le diamant (le temps de contact est de 3 secondes). La goutte est restée en contact entre une trentaine de secondes et une minute. Le diamant a ensuite été rincé avec du Phosphate Buffer Saline solution (PBS) qui contient du tampon phosphate, puis abondamment à l'eau.

### *Influence de la nature du solvant

Les images de fluorescence des surfaces greffées obtenues montrent que le taux de greffage optimal est atteint avec des solutions aqueuses basiques, mais d'autres solvants (DMSO) si l'on y a joute des ions hydroxydes peuvent également être utilisés mais avec des rendements de greffage inférieurs.

### *Spécificité du greffage

Les images de fluorescence des surfaces greffées obtenues montrent la spécificité du greffage en comparant le greffage de la biotine et celle de la biotine-PEO2-amine. La biotine est exempte de fonction amine et ne se greffe pas à la surface du diamant, alors que la biotine-PEO2-amine se greffe à la surface.

### *Application d'un potentiel lors du greffage

Les images de fluorescence des surfaces greffées obtenues montrent également l'effet lié à l'application d'un potentiel de 0,8 V lors du dépôt de la biotine-PEO2-amine. Ce potentiel se situe au pied de la vague d'oxydation de l'amine (pour une amine primaire ou secondaire). L'oxydation de l'amine n'est pas l'élément déclencheur du greffage compte tenu des fluorescences respectives obtenues avec ou sans application de potentiel.

### *Caractérisation des surfaces

La méthode de caractérisation qui a été utilisée est la microscopie de fluorescence, qui permet d'employer le couple biotine-avidine comme modèle biologique. Après greffage de la biotine-PEO2-amine, la révélation est réalisée par l'intermédiaire d'un fluorophore qui est la SAPE (Streptavidine-R-Phycoerythrine) (figure 1).

Le mode opératoire est le suivant. Après le greffage de la biotine-PEO2-amine, les étapes suivantes sont effectuées :
- Rinçage au PBS (Phosphate Buffer Saline solution qui contient du tampon phosphate, à 10 mM, du NaCl à 0,137 M et du KCI à 2,7 mM, à pH 7,4) puis à l'eau déionisée après greffage
- Dépôt de B.S.A. (Bovine Serum Albumine, Sigma Aldrich^{®}) pendant dix minutes.
- Rinçage au PBS.
- Incubation en présence de S.A.P.E (Molecular Probes^{®}) à 0,1 mg/mL dans du PBS, pendant dix minutes dans le noir.
- Rinçage au PBS.
- Révélation par fluorescence.

Le dépôt de BSA permet de bloquer le maximum de sites d'absorption non spécifiques situés à la surface du diamant. Ce phénomène s'accentue dans le cas du greffage de grosses molécules, et notamment pour les macromolécules comme les protéines, qui offrent une grande diversité de groupements fonctionnels situés à leurs contours. On palie à cet effet grâce à une protéine, la B.S.A. à une concentration de 1 mg/ml. On a déposé cette solution sur l'échantillon pendant dix minutes. Cela entraine l'adsorption de la B.S.A. sur la quasi-totalité des sites d'adsorption non spécifiques uniquement, en revanche les zones fonctionnalisées par la biotine ne constituent pas des zones d'absorption pour la protéine B.S.A., elle est donc évacuée par le rinçage au PBS précédent la formation du complexe biotine-streptavidine.

La phycoerythrine est la protéine comportant le fluorophore. La gamme de longueur d'onde excitatrice de ce dernier est comprise entre 496 et 565 nm et elle émet à 578 nm.

### * Stabilité du greffage évaluée dans des milieux agressifs

Après greffage de la biotine-PEO2-NH₂ sur un échantillon diamant, une étude complémentaire sur la stabilité du greffage dans des milieux agressifs a été menée :
L'échantillon a alors été immergé successivement dans différentes solutions neutre (tampon phosphate, pH=7,2), acide (H₂SO₄, pH=0,8) et basiques (KOH, pH=12,1 et pH=13,7) pendant 15 minutes dans un bain à ultra-sons. Ces expériences ont été réalisées sur une période de 2 mois.
A chaque étape, la présence de la biotine greffée sur la surface du diamant a été révélée par fluorescence.

Finalement, il s'est avéré que les contrastes de fluorescence n'évoluaient ni en fonction du temps, ni en fonction des différentes attaques.

Ces expériences permettent ainsi de conclure quant à la stabilité du greffage de molécules sur la surface du diamant via la présence d'amines.

### *Stabilité du greffage évaluée par l'intermédiaire de cycles répétés couplage-dénaturation

La stabilité du greffage a été évaluée par l'intermédiaire de cycles répétés couplage-dénaturation. La figure 2 montre l'évolution du contraste de fluorescence avec le temps de greffage. Par contraste on entend la normalisation du signal spécifique (fluorescence du plot moins fluorescence du fond) par rapport au signal du fond.

La figure 2 démontre l'efficacité du greffage. En effet, pour le temps le plus court, 1 min, le signal spécifique est 8 fois plus élevé que le signal de fond (contraste de 8). Comme précédemment introduit, le temps de greffage permet de densifier la surface en sonde biologique (biotine). Ceci démontre la possibilité de moduler le taux de couverture de la surface via la maîtrise du temps selon que l'on veuille avoir accès à une surface peu greffée (biocapteurs ampérométriques enzymatiques) ou à une surface « saturée » en molécules fonctionnelles (c.f. exemple 4).

La figure 3 présente l'évolution relative (exprimée en % du contraste initial) au cours des cycles de reconnaissance-dénaturation. Pour les cycles 5 et 6, la trypsine n'a pas été utilisée pour la régénération des biotines en surface du diamant : l'échantillon a seulement été rincé à l'alcool et à l'eau, puis séché. D'où la baisse de fluorescence liée au blocage de nombreux sites par un fluorophore dégradé en termes de propriétés spectrales.
Pour le cycle 17, la trypsine a régénéré les biotines en surface. Toutefois afin de montrer l'efficacité de la régénération de surface et de produire un blanc la surface a été soumise au protocole de couplage en l'absence de SAPE, d'où l'absence (attendue) de fluorescence.
Le cycle 18, après reconnaissance avec la SAPE permet de confirmer que la trypsine brise les liens entre la biotine et la streptavidine de la SAPE sans briser la liaison entre la surface du diamant et la biotine.

En termes de stabilité (figure 3), la constante d'association entre la biotine et la streptavidine étant très élevée, le lien entre ces molécules est brisé à l'aide d'une protéase, la trypsine qui dégrade enzymatiquement la SAPE (par fragmentation de la chaîne peptidique). Après digestion enzymatique, la biotine laissée libre peut à nouveau être impliquée dans le mécanisme de reconnaissance avec la SAPE. La fluorescence observée présente un certain degré de fluctuation (déjà observé pour d'autres techniques de greffage [Yang et al., Nature Materials 1, 253-257, 2002] et étant inhérent à la microscopie de fluorescence). Toutefois, pour les cycles 5 et 6, la fluorescence est moindre. En effet, la dégradation enzymatique de la SAPE n'a pas été effectuée. De fait, toute reconnaissance complémentaire par une nouvelle molécule fluorescente est bloquée et la diminution progressive de la fluorescence spécifique vient de la dégradation du fluorophore préalablement reconnu. La régénération par la trypsine (effectuée pour les cycles postérieurs de la figure 3) permet de retrouver un maximum de biotines disponibles et accessibles pour la SAPE qui sera introduite pour les révélations suivantes.

On assure de cette façon la reproductibilité des révélations successives.

### EXEMPLE 2 : Greffage de la biotine-PEO2-amine (amine primaire aliphatique) sur le diamant de façon localisée

### * Spotting

La localisation du greffage est menée par « spotting » (Genomic Solution^{®}) ce qui permet une parallélisation et une densification des dépôts. Un appareil de dépôt programmable déposant des gouttes de diamètre de 150 µm par contact avec le substrat a été utilisé. L'aiguille contenant la solution à déposer est remplie par capillarité à partir de bacs de chargement. Le temps de contact avec le substrat est de 3 secondes.

### * Microcontact printing

Cette technique consiste en la création d'un motif sur une surface par le dépôt d'un composé. Elle nécessite la fabrication d'un tampon en PDMS (polydiméthylsiloxane, sylgard 184 (V.W.R. ^{®})) comportant les motifs voulus, on imbibe ensuite le PDMS avec la solution à déposer, on sèche légèrement, puis le tampon est posé sur la zone à fonctionnaliser.

Les images de fluorescence obtenues montrent la faisabilité du greffage de la biotine-PEO2-amine par microcontact printing sur du diamant nanocristallin avec des plots de 200 µm.

### EXEMPLE 3 : Greffage de l'acide para-aminobenzoique (amine primaire aromatique) sur le diamant

Dans le cas des amines primaires aromatiques, des expériences ont été menées avec l'acide para-aminobenzoique (APAB, Sigma Aldrich^{®}). La première étape a consisté à greffer l'APAB (1mM) dans les mêmes conditions que la biotine-PEO2-amine (phosphate 0,1 M, temps de contact 15 minutes).

Le couplage du groupement acide de l'APAB avec le groupement amine de la biotine-PEO2-amine a ensuite été réalisé. Pour ce faire on a procédé premièrement à la formation de l'ester activé grâce à l'EDC (1-éthyl-3-(3-diméthylaminopropyl)carbodiimide, Sigma Aldrich^{®}) et le sulfo-NHS (Sigma Aldrich^{®}), ensuite au couplage de l'ester activé avec l'amine de la biotine-PEO2-amine.

### *Efficacité du greffage en fonction du pH de la solution ayant servi au greffage de l'APAB sur le diamant

Les images de fluorescence obtenues montrent qu'une augmentation du pH de la solution s'accompagne d'une augmentation de la fluorescence, et donc de l'efficacité du greffage. Le greffage est plus efficace lorsque la solution a un pH plus élevé.

Cette expérience permet d'apporter trois éléments valorisant la présente invention :
1. Elle démontre sans ambiguïté le greffage d'une amine aromatique,
2. Elle souligne la possibilité de rentrer sur une surface d'intérêt un primaire chimique permettant le greffage extemporané d'une fonction d'intérêt,
3. Elle introduit la possibilité d'un greffage multiple de la surface au travers d'une chimie différenciée.

### EXEMPLE 4 : Greffage de la pyridoacridone artificielle sur diamant et quantification du greffage

Pour estimer la quantité de molécules greffées sur la surface, nous avons choisi la méthode électrochimique. Nous avons greffé par l'intermédiaire d'une amine primaire aliphatique une molécule sonde contenant le couple électrochimique rapide et réversible quinone-imine. Cette molécule est une pyridoacridone artificielle modifiée par un bras polyamine, elle est notée PyAc ci-après. 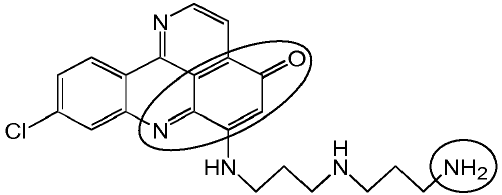 Molécule électrochimiquement active PyAc (le groupe électroactif quinone-imine et l'amine primaire aliphatique utilisée pour le greffage sont entourés).

Il a été procédé au greffage classique dans une solution de phosphate 0,1M à pH11 contenant 1 mM de PyAc pendant 30 min.

La caractérisation électrochimique par voltampérométrie cyclique de la surface greffée permet de conclure d'une part sur la réalité de l'immobilisation (évolution du courant de pic avec la vitesse de balayage en potentiel) et d'autre part sur la quantité de molécule greffée par unité de surface (via l'intégration de la charge sous les pics d'oxydation et de réduction).

La figure 5 montre l'évolution du courant des pics anodique et cathodique avec la vitesse de balayage en potentiel v. L'évolution caractéristique d'un système temporel, c'est-à-dire faisant intervenir une espèce immobilisée à la surface de l'électrode en quantité finie, est enregistrée avec une évolution des courants de pic directement proportionnelle à la vitesse de balayage.

La figure 4 montre un voltampérogramme typiquement enregistré pour une surface fonctionnalisée par le PyAc. L'intégration du courant sous le pic d'oxydation, à l'exclusion du courant capacitif (ou sous le pic de réduction) permet via la loi de Faraday de remonter à la quantité de molécules immobilisées par unité de surface sachant que la molécule PyAc échange 2 électrons par entité greffée. On peut évaluer notre taux de greffage à 7.10⁻¹¹ mol.cm⁻². Cette mesure valide l'obtention d'une monocouche relativement dense (pour cette taille de molécule, une couche compacte contient typiquement 10⁻¹⁰ - 10⁻¹¹ mol.cm⁻²).

### EXEMPLE 5 : Greffage de la biotine-PEO2-NH₂ sur silicium

L'hydrogénation de la surface du silicium a été effectuée par HF 48%, pendant 30 min, immédiatement suivie de la fonctionnalisation par la biotine-PEO2-NH₂.

Les conditions de greffage de l'exemple 1 ont été répétées en remplaçant le diamant par du silicium (phosphate 0,1 M, pH11, temps de contact 30 minutes). Les images de fluorescence obtenues et la comparaison des figures 6 et 7 démontrent que le greffage est effectif, et que la présence d'oxygène lors du greffage favorise le greffage.

### EXEMPLE 6 : Influence des paramètres de greffage de la biotine-PEO2-amine sur le diamant

Les solutions aqueuses utilisées étaient des solutions de tampon phosphate 0,1 M de pH 7.4, 8.4, 9.4, 10.4, et 11.4 pH 11. Le pH joue un rôle prépondérant dans le greffage, il permet la déprotonation de l'amine, ce qui renforce son caractère nucléophile. Le greffage n'est possible que si la fonction amine est au moins partiellement à l'état non protoné.

En raison de la faible dimension des plots, du glycérol (Sigma Aldrich^{®}) a été ajouté aux solutions aqueuses à hauteur de 1-20% en volume, de manière à limiter les phénomènes de séchage, dans le temps de fabrication du matériau greffé, que l'on a observé initialement sans ajout de glycérol.

Pour préparer les solutions de greffage, 15 ml de glycérol ont été dissous dans 35 ml d'eau ultra pure. 710 mg de phosphate de sodium (Na₂HPO₄) ont été dissous dans 50 ml de la solution eau-glycérol préalablement préparée, puis le pH a été ajusté aux différentes valeurs sus-citées avec de l'hydroxyde de sodium (NaOH) 3M. 19 mg de biotine-PEO2-amine (Pierce^{®}) ont été dissous dans la solution précédemment préparée.

Une aiguille d'une contenance de 80 µl a alors été remplie (voir partie spotting pour l'explication sur l'appareil de dépôt automatique), qui a déposé une goutte par contact avec le diamant (le temps de contact est de 3 secondes). La goutte est restée en contact avec le diamant hydrogéné pendant trois durées de greffage différentes de 10, 20 et 40 min. Le diamant a ensuite été rincé avec du Phosphate Buffer Saline solution (PBS) qui contient du tampon phosphate, puis abondamment à l'eau.

### * Caractérisation des surfaces

La méthode de caractérisation qui a été utilisée est la microscopie de fluorescence, qui permet d'employer le couple biotine-avidine comme modèle biologique. Après greffage de la biotine-PEO2-amine, la révélation est réalisée par l'intermédiaire d'un fluorophore qui est la SAPE (Streptavidine-R-Phycoerythrine) (figure 1).

Le mode opératoire était le suivant. Après le greffage de la biotine-PEO2-amine, les étapes suivantes ont été effectuées :
- Rinçage au PBS (Phosphate Buffer Saline solution qui contient du tampon phosphate, à 10 mM, du NaCl à 0,137 M et du KCI à 2,7 mM, à pH 7,4) puis à l'eau déionisée après greffage
- Dépôt de B.S.A. (Bovine Serum Albumine, Sigma Aldrich^{®}) pendant dix minutes.
- Rinçage au PBS.
- Incubation en présence de S.A.P.E (Molecular Probes^{®}) à 0,1 mg/mL dans du PBS, pendant dix minutes dans le noir.
- Rinçage au PBS.
- Révélation par fluorescence.

Le dépôt de BSA permet de bloquer le maximum de sites d'absorption non spécifiques situés à la surface du diamant. Ce phénomène s'accentue dans le cas du greffage de grosses molécules, et notamment pour les macromolécules comme les protéines, qui offrent une grande diversité de groupements fonctionnels situés à leurs contours. On palie à cet effet grâce à une protéine, la B.S.A. à une concentration de 1 mg/ml. On a déposé cette solution sur l'échantillon pendant dix minutes. Cela entraine l'adsorption de la B.S.A. sur la quasi-totalité des sites d'adsorption non spécifiques uniquement, en revanche les zones fonctionnalisées par la biotine ne constituent pas des zones d'absorption pour la protéine B.S.A., elle est donc évacuée par le rinçage au PBS précédent la formation du complexe biotine-streptavidine.

La phycoerythrine est la protéine comportant le fluorophore. La gamme de longueur d'onde excitatrice de ce dernier est comprise entre 496 et 565 nm et elle émet à 578 nm.

La figure 8 présente l'histogramme des intensités de fluorescence observés dans chacune des 15 couples pH-durée de greffage testés. Les différents spots ont une taille de 250 µm et sont arrangés sous forme d'un réseau spots (de 3 lignes et 5 colonnes) déposés sur un même diamant ce qui permet une étude comparative des paramètres.

Il apparaît alors clairement une évolution de la fluorescence en fonction des conditions, démontrant la possibilité de multiplexer une information intensive (en l'occurrence la concentration surfacique de biotine immobilisée) des spots sur un même support.

### * Influence du temps de greffage

Les images de fluorescence des surfaces greffées obtenues montrent que le taux de greffage augmente avec le temps de greffage. Les contrastes enregistrés et présentés en figure 8 présentent une augmentation continue de la fluorescence des spots avec un palier observé et attendu du fait d'une saturation de surface en fluorophore protéique.

Par contre, la fluorescence de la surface du diamant entre les spots (qui n'a pas été greffée) est faible et constante, démontrant la localisation spatiale du greffage sur les spots.

### * Influence du pH

Quelque soit le temps de greffage, les images de fluorescence des surfaces greffées obtenues montrent une évolution similaire. Aucun greffage n'est obtenu pour des pH inférieurs à 7,4 (car l'amine est complètement protonée). A partir de ce pH, même si la fraction d'amine déprotonée reste faible (de l'ordre de 1 %), le greffage est effectif avec des contrastes de fluorescence tout à fait significatifs (figure 8). Si la fraction molaire d'amine déprotonée augmente, en d'autres termes si le pH augmente, la contraste de fluorescence croit jusqu'à un pH optimum situé autours de 10,4 (et ce quelque soit le temps de greffage). Au delà, une légère décroissance du contraste est observée.

### EXEMPLE 7 : Greffage d'ADN-amine

Les solutions aqueuses utilisées étaient des solutions de tampon phosphate 0,1 M de pH 7.4. Le pH joue un rôle prépondérant dans le greffage, il permet la déprotonation de l'amine, ce qui renforce son caractère nucléophile. Toutefois, les brins d'ADN sondes immobilisés (- Zip9 : NH₂-(CH₂)₆-TTT-TTG-ACC-ATC-GTG-CGG-GTA-GGT-AGA-CC (SEQ ID NO:1) et Zip6: NH₂-(CH₂)₆-TTT-TTG-ACC-GGT-ATG-CGA-CCT-GGT-ATG-CG (SEQ ID NO :2), Eurogenetec) possèdent sur leurs bases nucléiques des amines aromatiques qui sont néanmoins nettement moins réactives. Le choix d'un pH de greffage bas permet alors d'une part de démontrer l'immobilisation de molécules fragiles dans des conditions non dénaturantes et, d'autre part, d'éviter l'inhibition du phénomène de reconnaissance ADN cible ADN sonde, l'hybridation, par le greffage des amines nucléiques impliquées dans la formation des liens hydrogènes et bases de la sélectivité dans le double brin.

En raison de la faible dimension des plots, du glycérol (Sigma Aldrich^{®}) a été ajouté aux solutions aqueuses à hauteur de 1-20% en volume de manière à limiter les phénomènes de séchage, dans le temps de fabrication du matériau greffé (biopuce à ADN), que l'on a observé initialement sans ajout de glycérol.

Pour préparer les deux solutions de greffage, 15 ml de glycérol ont été dissous dans 35 ml d'eau ultra pure. 710 mg de phosphate de sodium (Na₂HPO₄) ont été dissous dans 50 ml de la solution eau-glycérol préalablement préparée, puis le pH a été ajusté à pH7.4 avec de l'hydroxyde de sodium (NaOH) 3M. 1µm de chacun des oligonucléotide-amine ont été dissous dans les deux solutions précédemment préparées.

Une aiguille d'une contenance de 80 µl a alors été remplie avec l'une des solutions d'ADN-sonde aminé (voir partie spotting pour l'explication sur l'appareil de dépôt automatique), qui a déposé une goutte par contact avec le diamant (le temps de contact est de 3 secondes). La goutte (diamètre 250 µm) est restée en contact avec le diamant hydrogéné pendant 15 minutes. Le diamant a ensuite été rincé avec du Phosphate Buffer hydrogéné pendant 15 minutes. Le diamant a ensuite été rincé avec du Phosphate Buffer Saline solution (PBS) qui contient du tampon phosphate, puis abondamment à l'eau. Après rinçage à l'eau déionisée puis au tampon phosphate de l'aiguille de spotting puis séchage, un deuxième spot est réalisé avec le deuxième brin sonde aminé à une distance de 200 µm. Après un même temps de greffage, la surface de diamant est de nouveau rincée au tampon phosphate.

### * Caractérisation des surfaces

La méthode de caractérisation qui a été utilisée est la microscopie de fluorescence, qui permet d'employer le couple biotine-avidine comme révélateur de l'hybridation. Après greffage des deux oligonucléotide-amine en deux spots contigus mais distinctes de 200 µm de diamètre l'hybridation est menée en présence de l'un, de l'autre ou encore des deux brins complémentaires biotinylés puis la révélation est réalisée par l'intermédiaire d'un fluorophore qui est la SAPE (Streptavidine-R-Phycoerythrine) au travers du couplage avidine-biotine (figure 1).

Le mode opératoire était le suivant. Après le greffage de chacun des oligonucléotides-amine ZIP 6 et ZIP 9, les étapes suivantes ont été effectuées :
- Rinçage au PBS (Phosphate Buffer Saline solution qui contient du tampon phosphate, à 10 mM, du NaCl à 0,137 M et du KCI à 2,7 mM, à pH 7,4) puis à l'eau déionisée après greffage
- Dépôt d'une solution d'ADN complémentaire, 100nm, dans du tampon d'hybridation (solution de Denhart 1X, Sigma Aldrich^{®}) pendant quinze minutes à 42°C.
- Rinçage au PBS.
- Incubation en présence de S.A.P.E (Molecular Probes^{®}) à 0,1 mg/mL dans du PBS, pendant dix minutes dans le noir.
- Rinçage au PBS.
- Révélation par fluorescence.

La présence dans la solution d'hybridation de Denhart contenant des tensioactifs, de la BSA (bovine Serum Albumin) et de l'ADN double brin de sperme de saumon, permet de bloquer le maximum de sites d'absorption non spécifiques situés à la surface du diamant. La révélation par la SAPE ne nécessite plus de blocage de la surface du fait de l'utilisation préalable du tampon d'hybridation.

Le contraste de fluorescence est mesuré
1) après hybridation avec le complémentaire biotinylé de la sonde ZIP6,
2) puis du complémentaire biotinylé ZIP 9 et
3) enfin avec les deux complémentaires simultanément présents dans la solution d'hybridation.

Chacune de ces trois étapes est menée de manière séquentielle. Après la première révélation, la surface est dénaturée à la soude 0.2 M pendant 1 min. L'action de la soude permet de rompre les liaisons hydrogènes qui assurent le maintient du double brin et permet de libérer la surface ne laissant que les brins sondes greffés. Cette dernière est alors rincée abondamment avec de l'eau puis un tampon, de rinçage (PBS) avant d'opérer une nouvelle révélation avec un deuxième brin cible en solution.

Par ajout du brin complémentaires à la sonde ZIP 6 (étape 1), seul le plot portant la sonde afférente ZIP 6 s'éclaire. Le contraste de fluorescence obtenu entre spot spécifique et non spécifique (spot ZIP 9) est de l'ordre de 8. Ce contraste est identique à celui calculé entre zone hybridée et zone non modifiée.

Après dénaturation et rinçage, la cible complémentaire au brin ZIP 9 est injectée dans la solution d'hybridation (en absence de complémentaire ZIP 6) (étape 2). Seul le plot ZIP 9 s'éclaire avec des contrastes de fluorescence similaires.

Enfin, après dénaturation et rinçage, les deux cibles sont injectées simultanément dans la solution d'hybridation (étape 3). Après révélation, les deux plots s'allument avec des contrastes de fluorescence similaires.

Cette expérience démontre d'une part la stabilité du greffage (pas de perte de fluorescence sur 3 cycles hybridation-dénaturation) et d'autre part, et surtout, la possibilité de multiplexer sur un même support l'information biologique avec une excellente résolution spatiale.

## Revendications

1. Procédé de préparation d'un matériau greffé comprenant les étapes suivantes :
a) fournir un matériau qui comprend en surface des atomes de carbone, silicium et/ou germanium à l'état d'hybridation sp³ et porteurs d'au moins un atome d'hydrogène, et
b) mettre en contact dans un solvant le matériau tel que fourni dans l'étape a) avec un composé (C) porteur d'au moins une fonction amine à l'état non protoné, ledit composé (C) étant au moins partiellement soluble dans ledit solvant, ce par quoi ledit composé (C) se greffe sur ledit matériau.

2. Procédé selon la revendication 1, dans lequel l'étape b) est réalisée en présence d'oxygène.

3. Procédé selon la revendication 1 ou 2, dans lequel l'étape b) est réalisée en présence d'eau.

4. Procédé selon l'une quelconque des revendications 1 à 3, dans lequel le matériau comprend au moins une couche de surface constituée de l'un des éléments choisis parmi le carbone, le silicium, le germanium et leurs mélanges.

5. Procédé selon l'une quelconque des revendications 1 à 4, dans lequel le matériau fourni dans l'étape a) est issu d'une étape d'hydrogénation d'un matériau initial dont la surface comporte des atomes de carbone, silicium et/ou germanium à l'état d'hybridation sp³, initialement non hydrogénés ou non totalement hydrogénés.

6. Procédé selon la revendication 5, dans lequel le matériau fourni dans l'étape a) est issu d'une étape d'hydrogénation par plasma H₂ d'un matériau initial dont la surface comporte du diamant, du silicium ou du germanium, initialement non hydrogéné ou partiellement non hydrogéné.

7. Procédé selon la revendication 5, dans lequel le matériau fourni dans l'étape a) est issu d'une étape d'hydrogénation par traitement par de l'acide fluorhydrique d'un matériau initial dont la surface comporte du silicium ou du germanium initialement non hydrogéné ou partiellement non hydrogéné.

8. Procédé selon l'une quelconque des revendications 1 à 4, dans lequel le matériau comprend en surface du diamant de synthèse.

9. Procédé selon la revendication 8, dans lequel le matériau comprend en surface du diamant de synthèse fraîchement préparé.

10. Procédé selon la revendication 9, dans lequel le matériau comprend en surface du diamant de synthèse en sortie de bâti de croissance d'une méthode de croissance en phase vapeur (CVD).

11. Procédé selon l'une quelconque des revendications 1 à 10, dans lequel la fonction amine est une fonction amine primaire ou secondaire.

12. Procédé selon la revendication 11, dans lequel la fonction amine est une fonction amine primaire.

13. Procédé selon l'une quelconque des revendications 1 à 12, dans lequel le composé (C) porteur d'une fonction amine est une molécule fonctionnelle.

14. Procédé selon la revendication 13, dans lequel la molécule fonctionnelle est une molécule active au sens du transfert d'énergie choisie parmi un complexe métallique, un complexe bioinorganique, un composé redox organique, bioorganique ou organo-inorganique, un fluorophore, un chromophore, ou une molécule biologique choisie parmi l'acide désoxyribonucléique (ADN), l'acide ribonucléique (ARN), une protéine, un peptide, une enzyme, un anticorps, un carbohydrate.

15. Procédé selon l'une quelconque des revendications 1 à 14, dans lequel le greffage des composés (C) est réalisé de façon localisée sur une partie déterminée de la surface.

## Patentansprüche

1. Verfahren für die Herstellung eines gepfropften Materials, das die folgenden Schritte umfasst:
a) Bereitstellen eines Materials, das auf der Oberfläche Kohlenstoff-, Silizium- und/oder Germaniumatome im Hybridisierungszustand sp³ umfasst, die mindestens ein Wasserstoffatom tragen, und
b) Inkontaktversetzen in einem Lösungsmittel des Materials aus Schritt a) mit einer Verbindung (C), die mindestens eine Aminfunktion in nicht protoniertem Zustand trägt, wobei die Verbindung (C) mindestens teilweise in dem Lösungsmittel löslich ist, weswegen sich die Verbindung (C) auf das Material pfropft.

2. Verfahren nach Anspruch 1, wobei der Schritt b) in Anwesenheit von Sauerstoff durchgeführt wird.

3. Verfahren nach Anspruch 1 oder 2, wobei der Schritt b) in Anwesenheit von Wasser durchgeführt wird.

4. Verfahren nach einem der Ansprüche 1 bis 3, wobei das Material mindestens eine Oberflächenschicht umfasst, die von einem der Elemente gebildet ist, die aus dem Kohlenstoff, dem Silizium, dem Germanium und ihren Gemischen ausgewählt sind.

5. Verfahren nach einem der Ansprüche 1 bis 4, wobei das in Schritt a) bereitgestellte Material aus einem Hydrogenisierungsschritt eines Ausgangsmaterials hervorgegangen ist, dessen Oberfläche Kohlenstoff-, Silizium- und/oder Germaniumatome im Hybridisierungszustand sp³ umfasst, die ursprünglich nicht hydrogenisiert oder nicht vollständig hydrogenisiert sind.

6. Verfahren nach Anspruch 5, wobei das in Schritt a) bereitgestellte Material aus einem Hydrogenisierungsschritt durch Plasma H₂ eines Ausgangsmaterials hervorgegangen ist, dessen Oberfläche Diamant, Silizium oder Germanium aufweist, die ursprünglich nicht hydrogenisiert oder teilweise nicht hydrogenisiert sind.

7. Verfahren nach Anspruch 5, wobei das in Schritt a) bereitgestellte Material aus einem Hydrogenisierungsschritt durch Behandlung durch die Fluorwasserstoffsäure eines Ausgangsmaterials hervorgegangen ist, dessen Oberfläche Silizium und Germanium aufweist, das ursprünglich nicht hydrogenisiert oder teilweise nicht hydrogenisiert ist.

8. Verfahren nach einem der Ansprüche 1 bis 4, wobei das Material auf der Oberfläche synthetischen Diamant umfasst.

9. Verfahren nach Anspruch 8, wobei das Material auf der Oberfläche frisch hergestellten synthetischen Diamant umfasst.

10. Verfahren nach Anspruch 9, wobei das Material auf der Oberfläche synthetischen Diamant vom Ausgang des Wachstumsapparats einer Wachstumsmethode in der Dampfphase (CVD) umfasst.

11. Verfahren nach einem der Ansprüche 1 bis 10, wobei die Aminfunktion eine primäre oder sekundäre Aminfunktion ist.

12. Verfahren nach Anspruch 11, wobei die Aminfunktion eine primäre Aminfunktion ist.

13. Verfahren nach einem der Ansprüche 1 bis 12, wobei die Verbindung (C) als Träger einer Aminfunktion ein Funktionsmolekül ist.

14. Verfahren nach Anspruch 13, wobei das Funktionsmolekül ein aktives Molekül im Sinne der Übertragung von Energie ist, ausgewählt aus einem Metallkomplex, einen bio-anorganischem Komplex, einer organischen, bioorganischen oder organisch-anorganischen Redoxverbindung, einem Fluorophor, einem Chromophor oder einem biologischen Molekül, das aus der Desoxyribonukleinsäure (DNA), der Ribonukleinsäure (RNA), einem Protein, einem Peptid, einem Enzym, einem Antikörper, einem Carbohydrat ausgewählt ist.

15. Verfahren nach einem der Ansprüche 1 bis 14, wobei das Pfropfen der Verbindungen (C) lokal in einem bestimmten Bereich der Oberfläche durchgeführt wird.

## Claims

1. A method for preparing a grafted material comprising the following steps:
a) providing a material which, on its surface, comprises sp³ hybridized carbon, silicon and/or germanium atoms carrying at least one hydrogen atom, and
b) contacting in a solvent the material as provided at step a) with a compound (C) carrying at least one amine function in the unprotonated state, said compound (C) being at least partially soluble in said solvent, whereby the said compound (C) is grafted onto the said material.

2. The method according to claim 1, wherein step b) is conducted in the presence of oxygen.

3. The method according to claim 1 or 2, wherein step b) is conducted in the presence of water.

4. The method according to any of claims 1 to 3, wherein the material comprises at least one surface layer formed of one of the elements selected from among carbon, silicon, germanium and mixtures thereof.

5. The method according to any of claims 1 to 4, wherein the material provided at step a) is derived from a hydrogenation step of an initial material whose surface comprises sp³ hybridized carbon, silicon and/or germanium atoms, initially non-hydrogenated or not fully hydrogenated.

6. The method according to claim 5 wherein the material provided at step a) is derived from a hydrogenation step by H₂ plasma of an initial material whose surface comprises diamond, silicon or germanium, initially non-hydrogenated or partly non-hydrogenated.

7. The method according to claim 5, wherein the material provided at step a) is derived from a hydrogenation step by treatment with hydrofluoric acid of an initial material whose surface comprises silicon or germanium initially non-hydrogenated or partly non-hydrogenated.

8. The method according to any of claims 1 to 4 wherein the material, on its surface, comprises synthetic diamond.

9. The method according to claim 8 wherein the material, on its surface, comprises freshly prepared synthetic diamond.

10. The method according to claim 9 wherein the material, on its surface, comprises synthetic diamond on leaving the growth apparatus of a vapour phase growth method (CVD).

11. The method according to any of claims 1 to 10 wherein the amine function is a primary or secondary amine.

12. The method according to claim 11 wherein the amine function is a primary amine.

13. The method according to any of claims 1 to 12 wherein compound (C) carrying an amine function is a functional molecule.

14. The method according to claim 13, wherein the functional molecule is an active molecule in the meaning of energy transfer chosen from a metallic complex, a bioinorganic complex, an organic, bioorganic or organo-inorganic redox compound, a fluorophore, a chromophore, or a biological molecule selected from among deoxyribonucleic acid (DNA), ribonucleic acid (RNA), a protein, a peptide, an enzyme, an antibody, a carbohydrate.

15. The method according to any of claims 1 to 14, wherein the grafting of compounds (C) is performed in localized manner on a determined part of the surface.
